# EUROPÄISCHE PATENTANMELDUNG

(11) **EP 1 577 419 A1**
(43) Veröffentlichungstag der Anmeldung: **21.09.2005**
(21) Anmeldenummer: 04010241.0
(22) Anmeldetag: 30.04.2004
(51) Int. Cl.: C23C 14/56, C23C 16/54, F16K 51/02, F16K 3/18

(54) **Anlage zum Beschichten von Hohlkörpern, insbesondere von Kunststoffflaschen, mit einem Hochvakuumbereich und einer Schleuse**

(30) Priorität: 16.03.2004 DE 10412663
(71) Anmelder: Applied Films GmbH & Co. KG, 63755 Alzenau (DE)
(72) Erfinder: Michael, Klaus, Dr., 63571 Gelnhausen (DE); Gebele, Thomas, 63579 Freigericht (DE); Henrich, Jürgen, 63694 Limeshain (DE); Grimm, Helmut, Dr., 64291 Darmstadt (DE)
(74) Vertreter: Hebing, Norbert

(57) **Zusammenfassung**

Kunststoffflaschen wie auch andere Hohlkörper werden in Hochvakuumbeschichtungsanlagen mit dünnen Funktionsschichten versehen. Der dazu notwendige Prozess findet im Hochvakuum statt. Die zu beschichtenden Flaschen bzw. die beschichteten Flaschen werden mittels einer Schleuse, die aus einer Karussell-Trommeleinheit besteht, in die Hochvakuumkammer (20) eingebracht. Durch den Druckunterschied zwischen der Atmosphäre und der Hochvakuumkammer ergibt sich eine Verschiebung bzw. Kippung des Karussells in der Trommel, was die Abdichtung des Karussells gegenüber der Trommel schwierig macht. Die Erfindung schlägt daher ein aus zwei Schleusen (23, 25) der genannten Art bestehendes Schleusensystem vor, die über eine Zwischenvakuumkammer (22) miteinander verbunden sind. Dadurch wird erreicht, dass die Druckbelastung einer jeden Trommel (3) sinkt, so dass jede Schleuse (23, 25) weniger störanfällig arbeitet.

## Beschreibung

Die Erfindung bezieht sich auf eine Anlage zum Beschichten von Hohlkörpern, insbesondere von Plastikflaschen, mit einem Hochvakuumbereich und einer Schleuse zum Beschicken der Hochvakuumkammer mit den zu beschichtenden Hohlkörpern, wobei die Schleuse aus einer Trommel und einem darin drehbar angeordneten Karussell besteht, das an seiner Außenseite zur Aufnahme der Hohlkörper mehrere Ausnehmungen aufweist, und wobei das Karussell ober- und unterhalb der Ausnehmungen mit zwei umlaufenden Ringdichtungen versehen ist und sich zwischen den Ringdichtungen Längsdichtungen zwischen den Ausnehmungen erstrecken und wobei die Trommel in ihrer Mantelfläche zwei gegenüberliegende Öffnungen aufweist, durch die hindurch die Hohlkörper in die Ausnehmungen eingebracht bzw. entnommen werden können.

Eine derartige Anlage ist z. B. in der DE 198 07 031 A1 beschrieben. Bei dieser Anlage sind auf dem Umfang mehrere an ein Pumpensystem angeschlossene Ansaugstutzen vorgesehen. Die Ausnehmungen passieren mit fortschreitender Drehung des Karussells die Ansaugstutzen und werden somit stufenweise evakuiert. Diese hat sich für den Einsatz in kleinem Maßstab bewährt. Es treten aber Probleme auf, wenn zur Erhöhung des Durchsatzes entweder die Drehgeschwindigkeit des Karussells erhöht oder ein Karussell mit größerem Durchmesser eingesetzt werden soll. Wegen der Druckdifferenz zwischen der Atmosphäre und der Beschichtungskammer (Hochvakuumbereich) wirkt auf das Karussell eine Kraft in Richtung des Hochvakuumbereichs.

Dies hat zur Folge, dass das Karussell ein wenig exzentrisch zur Trommel verläuft und damit die Breite des zu dichtenden Ringspaltes zwischen der Mantelfläche des Karussells und der Innenwand der Trommel über den Umfang der Trommel variiert, so dass die Anforderungen an die Ringdichtungen wachsen. Das Problem wird noch größer, wenn das Karussell nur einseitig gelagert wird. Dann tritt gleichzeitig eine Kippung auf, die der Ringdichtung eine taumelnde Bewegung aufzwingt, was zu ihrem raschen Verschleiß führt.

Die Erfindung beruht somit auf dem Problem, ein Schleusensystem zu realisieren, das dauerhaft ohne Wartung arbeitet, was insbesondere heißt, dass die Dichtungen einem geringen Verschleiß unterliegen. Außerdem soll die Dichtung trotz einfacher Bauweise dauerhaft eine gute Dichtleistung erbringen.

Zur Lösung des Problems sieht die Erfindung eine Anlage gemäß dem Oberbegriff des Anspruchs 1 vor, bei dem das Schleusensystem aus einer ersten und einer zweiten Schleuse der im Oberbegriff genannten Art besteht und eine Zwischenkammer aufweist, in der ein Druck herrscht, der zwischen dem Atmosphärendruck und dem Druck in der Hochvakuumkammer liegt, wobei die erste Schleuse die Atmosphäre mit der Zwischenvakuumkammer und die zweite Schleuse die Zwischenvakuumkammer mit der Hochvakuumkammer verbindet.

Durch diese Maßnahme verringert sich die Druckdifferenz an den beiden Schleusen, so dass selbst bei einseitiger Lagerung der Karussells keine oder nur geringe Kippungen der Karussellachsen zu erwarten sind. Dadurch ergibt sich über den Umfang des Karussells betrachtet ein gleichbleibendes Spaltmaß, das mit einfachen Mitteln zu dichten ist.

Vor allem für die zweite Schleuse kann sogar auf Labyrinthdichtungen zurückgegriffen werden, da die Zwischenvakuumkammer relativ klein gehalten werden kann, so dass dort keine großen Luftmengen vorhanden sind, die in die Hochvakuumkammer einströmen könnten.

Grundsätzlich kann die Zwischenkammer aber auch als Prozesskammer ausgebildet werden, in der Vor- bzw. Nachbehandlungen des in der Hochvakuumkammer beschichteten Körpers erfolgen können.

Zum Beschicken bzw. Entladen der Schleuse sind jeweils Transfereinrichtungen, sogenannte Tranfersterne im Einsatz.

Im Folgenden soll anhand eines Ausführungsbeispieles die Erfindung näher erläutert werden. Dazu zeigen:
- Fig. 1: einen Querschnitt durch eine Schleuse;
- Fig. 2: einen Längsschnitt durch die Schleuse gemäß Figur 1;
- Fig. 3: einen Querschnitt durch Längsdichtungen an der Karussellwand;
- Fig. 4: eine alternative Ausführung einer Ringdichtung;
- Fig. 5: eine schematische Darstellung eines Zwei-Schritt-Schleusensystems mit einer zwischenvakuumkammer;
- Fig. 6: eine schematische Darstellung des Schleusensystems, bei dem die Zwischenkammer als Prozesskammer ausgebildet ist.

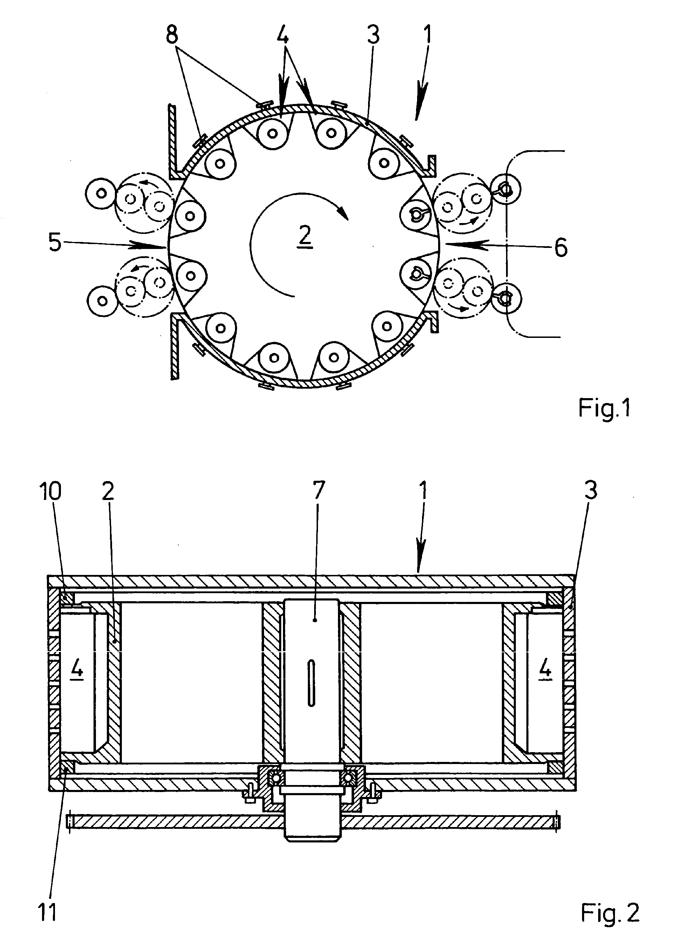

Zunächst wird auf die Figur 1 Bezug genommen. Eine Schleuse 1 besteht aus einem Karussell 2, das in einer Trommel 3 rotiert, wobei die Außenfläche des Karussells 2 an der Innenseite der Trommel 3 nahezu anliegt. In der Mantelfläche des zylinderförmigen Karussells 2 befinden sich nebeneinander mehrere Ausnehmungen 4 in Form von konisch zulaufenden Nuten, die sich über die Höhe des Karussells 2 erstrecken. Diese Ausnehmungen 4 dienen zur Aufnahme von Hohlkörpern, also z. B. von Flaschen.

Die Trommel 3 hat zwei gegenüberliegende Beschickungsöffnungen 5, 6. Diese sind so breit, dass auf jeweils zwei Ausnehmungen 4 zugegriffen werden kann. Somit kann an jeder Öffnung 5, 6 sowohl eine Flasche entnommen als auch eine Flasche der Schleuse 1 zugeführt werden.

Am Umfang verteilt befinden sich Ansaugstutzen 8, die ein stufenweises Evakuieren der Ausnehmungen 4 zwischen den beiden Beschickungsöffnungen 5, 6 ermöglichen. Insofern handelt es sich um eine Mehrstufenschleuse.

Wie man der Figur 2 entnehmen kann, ist das Karussell 2 auf einer Drehachse 7 gelagert, die einseitig am Boden der Trommel 3 drehbar gelagert ist. Das Karussell 2 verfügt an seiner Ober- und Unterseite über zwei umlaufende Ringdichtungen 10, 11, die den Ringspalt zwischen dem Karussell 2 und der Innenwand der Mantelfläche der Trommel 3 abdichten. Weiterhin erstrecken sich zwischen den Ausnehmungen 4 Längsdichtungen 12 (in Fig. 2 nicht gezeigt), die ebenfalls den Ringspalt zwischen Karussell 2 und Trommel 3 überbrücken.

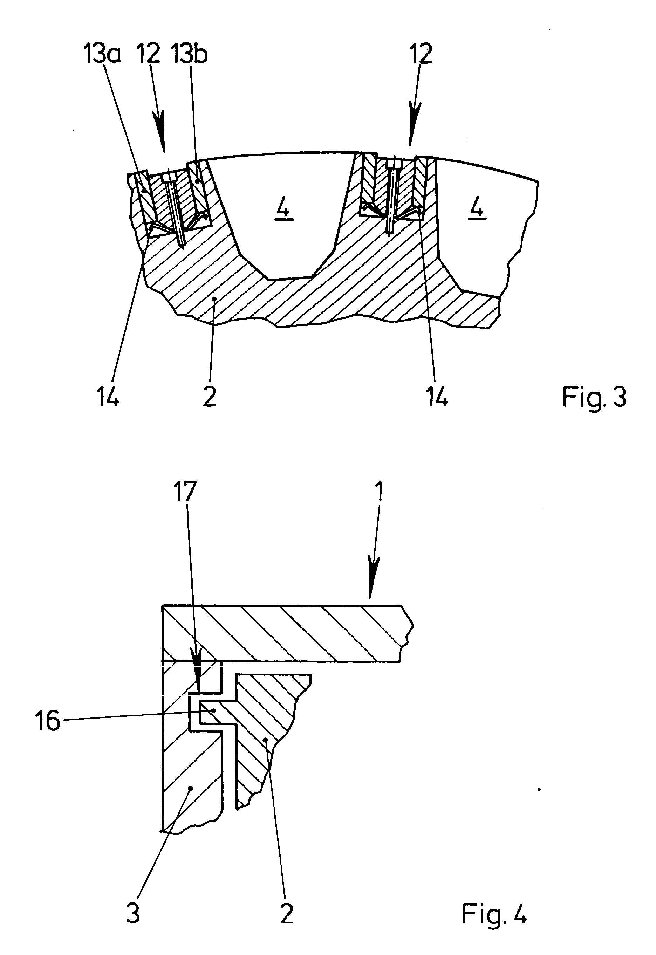

In der Figur 3 ist die Ausführung einer solchen Längsdichtung (12) gezeigt. Sie besteht jeweils aus einem Lippenpaar 13a, 13b, das durch eine Feder 14 nach außen vorgespannt ist.

Da sich die Längsdichtungen 12 an beiden Enden bis zu den Ringdichtungen 10, 11 erstrecken, ist jede Ausnehmung 4 allseitig umschlossen.

Wie man der Figur 2 entnehmen kann, kann es sich bei den Ringdichtungen 10, 11 um einfache Gummidichtungen handeln, die in entsprechenden Nuten am Karussell 2 liegen und mit der aus der Nut hervorstehenden Fläche gegen die Innenseite der Trommel 3 anliegen. Eine solche Dichtung kann auch als Labyrinthdichtung ausgeführt werden.

Die Figur 4 zeigt den Schnitt durch ein solches Labyrinth. Im einfachsten Fall handelt es sich um eine Nut 17 in der Trommel 3, in den ein radial nach außen abstehender Steg 16 eingreift. Die Abmessungen sind so gewählt, dass unter Berücksichtigung aller Toleranzen jeweils ein Spalt zwischen dem Steg 16 und dem Nutboden bzw. den Nutwänden verbleibt.

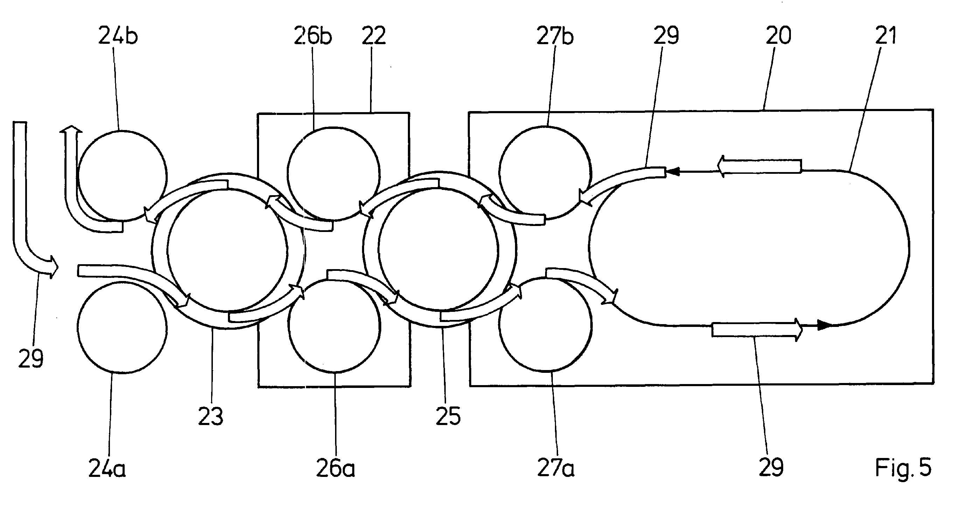

Eine solche Schleuse 1 kann nun in doppelter Ausführung zum Aufbau eines Zwei-Schritt-Schleusensystems gemäß Figur 5 genutzt werden.

Die Anlage besteht aus einer Hochvakuumkammer 20, die als Prozesskammer fungiert und in der entsprechende Prozesssysteme 21 zum Beschichten der Kunststoffflaschen vorgesehen sind. Vor dieser Hochvakuumkammer 20 befindet sich eine Zwischenvakuumkammer 22. Zum Beschicken dieser Kammer ist eine erste Schleuse 23 vorgesehen, die gemäß den Figuren 1 - 3 aufgebaut ist. Zum Be- und Entladen des Karussells 2 sind außen zwei Transfereinrichtungen 24a, 24b vorgesehen.

Zwischen der Zwischenvakuumkammer 22 und der Hochvakuumkammer 20 befindet sich eine zweite Schleuse 25, die ebenfalls entsprechend den Figuren 1 - 3 aufgebaut wird, wobei hier insbesondere eine Labyrinthdichtung gemäß Figur 4 vorgesehen werden kann. Zur Übergabe der Flaschen von der ersten Schleuse 23 zur zweiten Schleuse 25 sind in der Zwischenvakuumkammer 22 zwei weitere Transfereinrichtungen 26a, 26b vorgesehen.

Um die Flaschen zwischen der zweiten Schleuse 25 und dem Prozesssystem 21 auszutauschen, sind in der Hochvakuumkammer 20 ebenfalls Transfereinrichtungen 27a, 27b vorgesehen.

Die Flaschen durchlaufen somit sowohl zum Einschleusen in die Hochvakuumkammer 20 als auch zum Ausschleusen jeweils beide Schleusen 23, 25. Der Weg der Flaschen durch die Anlage ist durch die Pfeile 29 markiert.

Dieser etwas größere Aufwand wird kompensiert durch einen weniger störanfälligen Betrieb der Schleusen 23, 25, da beide Schleusen 23, 25 aufgrund des gesplitteten Druckunterschiedes nur geringeren Kräften ausgesetzt sind.

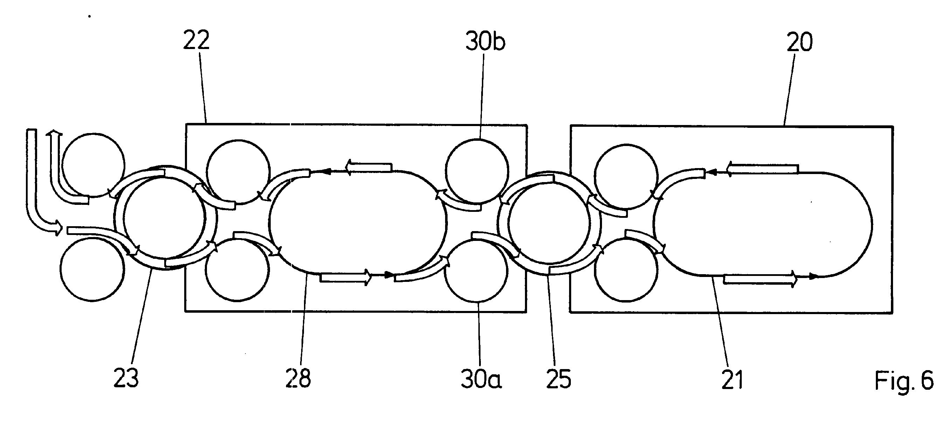

Die Einrichtung gemäß der Figur 6 entspricht der der Figur 5 mit dem Unterschied, dass die Zwischenvakuumkammer 22 ebenfalls als Prozesskammer fungiert, in der ein weiteres Prozesssystem 28 angeordnet ist. Dies macht ein zusätzliches Paar Transfereinrichtungen 30a, 30b notwendig. Da hier der Druck höher ist als in der Hochvakuumkammer 20, können hier natürlich nur Prozesse stattfinden, die zwar ein Vakuum, nicht aber zwingend ein Hochvakuum benötigen.

### Bezugszeichenliste

- 1: Schleuse
- 2: Karussell
- 3: Trommel
- 4: Ausnehmung
- 5: Beschickungsöffnung

- 6: Beschickungsöffnung
- 7: Drehachse
- 8: Absaugstutzen
- 9 10: Ringdichtung

- 11: Ringdichtung
- 12: Längsdichtung
- 13: Lippenpaar
14
15
- 16: Steg
- 17 18 19 20: Hochvakuumkammer

- 21: Prozesssystem
- 22: Zwischenvakuumkammer
- 23: erste Schleuse
- 24: Transfereinrichtungen
- 25: zweite Schleuse

- 26: Transfereinrichtungen
- 27: Transfereinrichtungen
- 28: Prozesssystem

- 29: Pfeil
- 30a, b: Transfereinrichtungen

## Patentansprüche

1. Anlage zum Beschichten von Hohlkörpern, insbesondere von Flaschen, mit einem Hochvakuumbereich und mit einer Schleuse zum Beschicken der Hochvakuumkammer mit den zu beschichtenden Hohlkörpern, wobei die Schleuse aus einer Trommel und einem darin drehbar angeordneten Karussell besteht, das an seiner Außenseite zur Aufnahme der Hohlkörper mehrere Ausnehmungen aufweist und wobei das Karussell ober- und unterhalb der Ausnehmungen mit zwei umlaufenden Ringdichtungen versehen ist und sich zwischen den Ringdichtungen Längsdichtungen zwischen den Ausnehmungen erstrecken und wobei die Trommel in ihrer Mantelfläche zwei gegenüberliegende Öffnungen aufweist, durch die hindurch die Hohlkörper in die Ausnehmungen eingebracht bzw. entnommen werden können, **dadurch gekennzeichnet, dass** ein Schleusensystem bestehend aus einer ersten (23) und zweiten Schleuse (25) der oben genannten Art vorgesehen ist sowie eine zwischenvakuumkammer (22), in der ein Druck herrscht, der zwischen der Atmosphäre und dem Druck in der Hochvakuumkammer (20) liegt und dass die erste Schleuse (23) die Atmosphäre mit der Zwischenvakuumkammer (22) und die zweite Schleuse (25) die Zwischenvakuumkammer (22) mit der Hochvakuumkammer (20) verbindet.

2. Anlage nach Anspruch 1, **dadurch gekennzeichnet, dass** das Karussell 2 einseitig gelagert ist.

3. Anlage nach Anspruch 1 oder 2, **dadurch gekennzeichnet, dass** die Ringdichtung (10, 11) der zweiten Schleuse (25) als Labyrinthdichtung ausgeführt ist.

4. Anlage nach einem der vorhergehenden Ansprüche, **dadurch gekennzeichnet, dass** die Zwischenvakuumkammer (22) als Prozesskammer fungiert.
